(19) Europäisches Patentamt
European Patent Office
Office européen des brevets

(11) Publication number: **0 021 716**
**B1**

(12) **EUROPEAN PATENT SPECIFICATION**

(45) Date of publication of patent specification: **15.02.84**

(51) Int. Cl.³: **G 03 F 7/08, C 08 G 8/28**

(21) Application number: **80301955.3**

(22) Date of filing: **10.06.80**

(54) **Condensation product and lithographic printing plates containing said product.**

(30) Priority: **16.06.79 JP 76217/79**

(43) Date of publication of application:
**07.01.81 Bulletin 81/1**

(45) Publication of the grant of the patent:
**15.02.84 Bulletin 84/7**

(84) Designated Contracting States:
**DE FR GB IT**

(56) References cited:
**DE - A - 2 146 166**
**DE - A - 2 146 167**
**DE - A - 2 512 933**
**FR - A - 2 312 799**
**GB - A - 1 227 602**
**JP - B - 49 024 361**
**US - A - 3 635 709**

(73) Proprietor: **KONISHIROKU PHOTO INDUSTRY CO. LTD.**
**No. 26-2, Nishishinjuku 1-chome Shinjuku-ku**
**Tokyo 160 (JP)**

(72) Inventor: **Uehara, Masafumi**
**2-2-19 Sakura-cho Koganei shi**
**Tokyo (JP)**
Inventor: **Shimada, Fumio**
**1410 Kumagawa**
**Fussa-shi Tokyo (JP)**
Inventor: **Iwaki, Akio**
**3-5-4 Mejirodai**
**Hachioji-shi Tokyo (JP)**
Inventor: **Matsuzaki, Masatoshi**
**5-2-2 Hinodai**
**Hino-shi Tokyo (JP)**
Inventor: **Ogawa, Yoko**
**3-17-6 Hon-cho**
**Higashimurayama-shi Tokyo (JP)**

(74) Representative: **Ellis-Jones, Patrick George Armine et al,**
**J.A. KEMP & CO. 14 South Square Gray's Inn**
**London WC1R 5EU (GB)**

**EP 0 021 716 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Condensation product and lithographic printing plates containing said product

The present invention relates to a condensation product and to a photosensitive composite used for a photosensitive lithographic printing plate and more particularly to a photosensitive composite of o-quinonediazide type.

It is known that when an o-quinonediazide compound is irradiated by an actinic radiation, it decomposes to produce a carboxylic acid of a 5 membered ring compound which is soluble in alkali, such that a photosensitive positive lithographic printing plate can be made therefrom. Many of these o-quinonediazide compounds have been known so far and most of them are compounds of low molecular weight, therefore when these o-quinonediazide compounds are used independently as a photosensitive material, crystals separate out and the physical strength of the image is so weak that printing of many sheets of paper is difficult. Therefore, together with o-quinonediazide compounds, an alkali-soluble resin such as a phenolformaldehyde resin, cresolformaldehyde resin or styreneanhydrous maleic acid resin has been used as a carrier. In such case, the development is done utilizing a change of alkali-solubility of low-molecular o-quinonediazide compound by the exposure, but due to the fact that an alkali-soluble resin is a carrier, there have been some weak points — the range of developer concentration with which the proper development can be reproduced is narrow and non-exposed portion is lost remarkably or a part of the image is damaged and dissolved when developed.

Some examples of polymerizing the photosensitive substance itself to improve the abovementioned weak points are known.

U.S. Patent 3046120, Japanese Patent Publication Nos. 43—28403, 49—24361, 50—5083 and 50—5084 and Japanese Patent L—O—P Publication No. 50—36206 are given as examples. Among these patents, U.S. Patent 3046120, Japanese Patent Publication No. 50—5083 and Japanese Patent L—O—P Publication No. 50—36206 disclose that the o-quinonediazide group is substituted in a condensation type resin of a phenol or a substituted phenol and an aldehyde. In a photosensitive resin produced from a condensation type resin of a phenol or a substituted phenol and an aldehyde, the hydroxyl group content decreases because of esterification with o-naphthoquinonediazidesulfonylchloride, and thereby the developing performance with an aqueous alkaline solution deteriorates considerably and the image strength is low; further the chemical resistance for various kinds of processing agents is poor, which might be caused by its low adhesion to the support especially to an aluminium plate. If the chemical resistance on the photosensitive layer is low, problems such as image reproducibility of low grade material and decreased durability for printing may arise.

On the other hand, as examples in which o-naphthoquinonediazide group is substituted in a condensation type resin of polyhydric phenol and an aldehyde or ketone group, Japanese Patent Publication Nos 43—28403, 49—24361 and 50—5084 may be given. In a photosensitive resin produced from a condensation type resin of polyhydric phenol and an aldehyde or ketone group, the developing performance by an aqueous alkaline solution and adhesion to the support especially to an aluminium plate are relatively excellent but hydrophobicity is poor due to too many hydroxyl groups contained therein such that the ink acceptability is poor and the chemical resistance for various processing agents is still insufficient. If the ink acceptability of the photosensitive layer is poor, problems such as the reduction of image density in prints and a fall in the durability for printing or difficulties in keeping the balance between water and ink for printing may arise.

The object of the present invention is therefore to offer a photosensitive composite for a lithographic printing plate in which such disadvantages and weak points of the conventional photosensitive composite are mitigated or eliminated.

The photosensitive composite of the present invention possesses good preservability, good film forming performance and good adhesion to an aluminium support, and a lithographic printing plate made from the said photosensitive composite has excellent developability, resistance to processing agents, and ink acceptability of the developed printing plate compared with those made from a conventional photosensitive composite.

We have found a photosensitive condensation product of a sulfonylchloride of an o-benzoquinonediazid or o-naphthoquinonediazid and polyhydroxyphenyl resin shown in the following general formula:

General formula

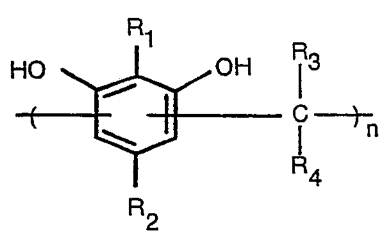

(In the formula, $R_1$ is alkyl group having 1 to 8 carbon atoms, $R_2$ is a hydrogen or halogen atom, or a

lower alkyl or alkoxy group (number of carbon: 1—4), $R_3$ and $R_4$ is hydrogen atom or a lower alkyl group (number of carbon: 1—4) or a phenyl group, and "n" is an integer of 3 or more.)

This resin can be synthesized by reacting a polyhydric phenol and an aldehyde or ketone.

As for examples of the polyhydric phenol, the following are given: 2-methylresorcinol, 2-ethylresorcinol, 2-propylresorcinol, 2-isopropylresorcinol,, 2-t-butylresorcinol, 2-pentylresorcinol, 2-hexylresorcinol, 2-octylresorcinol, 2-methyl-5-chloresorcinol, 2-ethyl-5-chloresorcinol, 2,5-dimethylresorcinol, 2-methyl-5-ethylresorcinol, 2-methyl-5-methoxyresorcinol, 2,5-diethylresorcinol, 2-t-butyl-5-methylresorcinol, 2-t-butyl-5-methylresorcinol, etc., and among the above, 2-methylresorcinol or 2-ethylresorcinol (namely $R_1$ is a methyl or ethyl group in the formula) are particularly preferable.

As for the examples of aldehyde or ketone, the following are given; formaldehyde, acetaldehyde, propylaldehyde, butylaldehyde, benzaldehyde, acetone, methylethylketone, diethylketone, acetophenone, etc.; among the above, acetaldehyde or acetone (namely in case that $R_3$ is a methyl group or a hydrogen atom and $R_4$ is a methyl group in the formula) are particularly preferable.

Polyhydroxyphenyl resin with the aforementioned general formula in the present invention can be made as follows. Namely, when 1 mol of the aforesaid polyhydric phenol and 0.85—1.0 mol of the aforesaid aromatic aldehyde or ketone group by themselves or in an alcoholic solution are condensed with an acid catalyst such as hydrochloric acid and oxalic acid or an alkaline catalyst such as sodium hydroxide and aqueous ammonia, then a desired resin may be obtained. It is possible to obtain different molecular weights by changing the mol ratio for the monomers and the condensation reaction conditions. However, preferably n in the general formula has a value so that the molecular weight of the resin is about 600—10000 preferably about 800—4000.

A typical example of synthesis of polyhydroxyphenyl resin for use in the present invention is given as follows.

### Synthesis example 1

2-methylresorcinol, 621 g is dissolved in 1 l of ethanol and then 20 g of acetaldehyde is added thereto and as a catalyst 0.5 ml of 35% concentrated hydrochloric acid is added. The mixture is stirred and heated in an oil bath and after the start of boiling (reflux) of the reacting mixture caused by the heat of reaction, heating is reduced slightly, and for another 90 minutes heating and reflux are continued. After the reaction, the reacted mixture is poured into 5 l of cold water with stirring, thereby a powder resin of light-brown color is obtained. The yield thereof is 637 g. The molecular weight of this condensation product measured by osmotic pressure is about 2100.

### Synthesis example 2

In 1 l of acetone, 621 g of 2-methylresorcinol is dissolved and as a catalyst 30 g of phosphorusoxychloride is added. After the mixture is stirred for 24 hours at room temperature, it is poured, with stirring, into 10 l of cold water. Powdered resin of light-brown color is obtained. The yield thereof is 656 g. The molecular weight of this condensation product measured by osmotic pressure is about 2000.

### Synthesis example 3

In 1 l of dioxane, 690 g of 2-ethylresorcinol is dissolved and then 530 g of benzaldehyde is added, and 30 g of phosphorusoxychloride is added as a catalyst. The mixture is stirred for 24 hours at room temperature. After the reaction, the reacted mixture is poured, with stirring, into 5 l of cold water, thereby powdered resin of light-brown color is obtained. The yield thereof was 1073 g. The molecular weight of this condensation product measured by osmotic pressure is about 1800.

### Synthesis example 4

In 1 l of ethanol, 691 g of 2,5-dimethylresorcinol is dissolved and then 348 g of 37% formaldehyde and as a catalyst, 0.5 ml of 35% concentrated hydrochloric acid are added. The mixture is heated, with stirring, in the oil bath and after the start of boiling (reflux) of the reacting mixture caused by the heat of reaction, heating was slightly reduced and heating and stirring were continued for 90 minutes. After the reaction, the reacted mixture is poured, with stirring, into 5 l of cold water; thereby a powder type resin of light-brown color is obtained. The yield thereof is 683 g. The molecular weight of this condensation product measured with the method of osmotic pressure is about 1500.

Other polyhydroxyphenyl resins can be synthesized in the same or similar manner.

Specific sulfonylchlorides of o-benzoquinonediazide or o-naphthoquinonediazide which can be used in the present invention include 4-chlorosulfonyl-o-benzoquinonediazide, or 4-chloro-sulfonyl-o-naphthoquinonediazide or 5-chlorosulfonyl-o-naphthoquinonediazide. The condensation product of the sulfonylchloride of o-benzoquinonediazide or of o-naphthoquinonediazide (which is referred as a "sulfonylchloride of diazide compound" hereinafter) and polyhydroxyphenyl resin can be synthesized as follows. Namely, the sulfonylchloride of diazide compound and polyhydroxyphenyl resin are dissolved in a solvent such as dioxane or tetrahydrofuran and alkali such as sodium carbonate or potassium carbonate is added with stirring and heating at 40—50°C, which causes esterification. For all polyhydroxyphenyl resin prepared in the examples of the present specification, the yield is more than 90%.

Regarding the reaction ratio of the sulfonylchloride of diazide compound to polyhydroxyphenyl resin, the molar ratio is typically 1:0.4—1:2.0, preferably 1:0.5—1:1.5, and the weight ratio is typically 1:0.5—1:3, preferably 1:0.7—1:2. It is preferably that these condensation products are used by themselves but, if circumstances require, it is possible to mix them with an alkali soluble novolak resin in various proportions; by changing this mixing ratio, it is possible to freely regulate the developability of the photosensitive layer by aqueous alkaline solution. The resulting condensation product of the present invention is suitably dissolved in a solvent such as the monomethylether or monoethyl ether of ethylene glycol, ethylene glycol monomethyl ether acetate, dioxane and methylethylketone and coated onto an appropriate support such as an aluminium plate, zinc plate, copper plate, magnesium plate, plastic film and paper, among which the aluminium plate is most suitable. A range for the coating weight of the photosensitive layer of 0.1—4g/$m^2$ proved to be satisfactory for a printing plate and the range of 1—3 g/$m^2$ is especially satisfactory. The abovementioned photosensitive composite can contain various additives which have been used in such layers.

As for the original plate onto which the condensation product of the present invention is coated, a relief image of positive-positive type can be obtained by contacting the original picture having line drawing or half-tone dot image with the photosensitive surface for exposure and by developing with aqueous alkaline solution. As a light source suitable for the exposure, carbon arc lamp, xenon lamp, mecury lamp, chemical lamp, photographic flash lamp and tungsten lamp can for example be used and as a typical actual example of aqueous alkaline solution for the development, aqueous solutions of sodium hydroxide potassium hydroxide, calcium hydroxide, sodium carbonate, potassium carbonate, sodium metaborate tertiary sodium phosphate, secondary sodium phosphate, sodium metasilicate and sodium formate etc. may be given as examples.

A lithographic printing plate, of which the photosensitive layer contains a resin of the present invention has superior development performance to that of a diazoxide of cresolformaldehyde resin which has been used in practice; the alkaline density of the developer can be 1/2 to 1/3 of that required for the diazoxide cresol-formaldehyde resin. Further a larger number of prints can be made with the image thus obtained without any necessity of applying an additive such as a sensitive improver because it has superb ink receptivity and chemical resistance. These effects are in all likelihood due to the nature of the polyhydroxy phenyl resin itself; thus it is likely that the superb ink receptivity is due to the presence of many alkyl groups in the side chains of alkyl derivatives of polyhydroxy phenyl resin and that the superb development performance is due to the presence of many unreacted hydroxyl groups therein. The presensitized plate used with the photosensitive composite of the present invention is a really useful one, as described above.

Further explanation will be made with reference to the following examples which further illustrate the present invention.

Example 1

In 1 l of ethylene glycol monoethyl ether, 100 g of condensation product of 7 parts by weight of 1,2-naphthoquinone-2-diazide-5-sulfonylchloride and 10 parts by weight of 2-methyl resorcinol-acetaldehyde resin (product of synthesis example 1) and 0.7 g of dye (Methylene Blue Cone, Registered Trade Mark of Sumitomo Chemical Co Ltd) are dissolved; thereby a photosensitive liquid is prepared and this photosensitive liquid is coated with a roller onto a grained aluminium plate to a thickness of 0.24 mm so that the weight after drying is 1.8 g per $m^2$.

On the surface of the photosensitive plate thus prepared, a positive transparent original picture is contacted and exposed for 40 seconds by a metalhalide lamp of 2 KW positioned at 70 cm distance. After the photosensitive plate is dipped in 2% aqueous solution of sodium metasilicate, the exposed portion is quickly dissolved and an offset printing plate having excellent ink receptivity and resistance to processing agent is obtained.

After this printing plate is set in an offset press and printing is made, it proved to possess excellent ink receptivity and a large number of prints with good image, were obtained.

Comparative example 1

In 1 l of ethylene glycol monoethyl ether, 100 g of condensation product of 7 parts by weight of 1,2-naphthoquinone-2-diazide-5-sulfonyl-chloride and 10 parts by weight of cresol-formaldehyde resin (phenol resin MP—707, Registered Trade Mark of Gun-ei Chemical Industry Co Ltd) and 0.7 g of dye (Crystalviolet made by Hodagaya Chemical Co Ltd) are dissolved; thereby a photosensitive liquid is prepared and this photosensitive liquid is coated onto the grained aluminum plate in the same manner as the aforesaid one so that the thickness of the coated layer after drying is 1.8 g/$m^2$.

The photosensitive plate thus prepared is exposed under the same conditions as aforesaid and then the development is attempted in the same manner in 2% solution of sodium metasilicate; this showed that it takes longer developing time and that ink adhered to the entire surface after applying ink. As the concentration of solution of sodium metasilicate is raised, it is found that the concentration with which the development is made perfectly under the same conditions as the case of the aforesaid polyhydroxyphenyl series was 6%.

When the printing plate thus obtained is used on an offset printer to print, it is found that the ink

receptivity is remarkably inferior and that the number of spoilt papers i.e. spoilage until printed matter having enough ink density can be obtained was approximately two times more than that when using alkyl derivatives of polyhydroxy phenyl and further that the printing durability thereof was approximately 2/3 of that of the said compared material.

The chemical resistance of the two kinds of the printing plates thus obtained are compared.

First, the durability against isopropylalcohol which is used with the Dahlgren damping system is examined. When the two printing plates are soaked in 50% solution of isopropylalcohol for an hour at room temperature, the ratio of the image loss of the plate coated with cresol-formaldehyde photosensitizer is 64 weight per cent, while that of the plate coated with polyhydroxyphenyl photosensitizer is 23 weight per cent. When a photosensitive binding quinonediazide group with a monomer (e.g. a combination of orthonaphthoquinone diazide sulfonyl ester of cumyl phenol and cresol-formaldehyde resin) is used as the photosensitive layer of the printing plate, the resistance against isopropylalcohol of the said printing plate corresponds to 93 weight per cent image loss ratio under the same conditions.

There are a number of chemicals used for processing printing plates, and the order of chemical resistance to all of them follows closely that given above.

For instance, the durability against ink (PS Plate Ink, PI—2, Registered Trade Mark of Fuji Photo Co., Japan) is also in a similar order, after the above described three kinds of printing plate are soaked for 30 minutes at room temperature, the photosensitive plates of cumyl phenol ester and of cresol formaldehyde are both harmed by the ink component and the aluminium surfaces thereof are partially bared whereas, on the other hand, the photosensitive substance of polyhydroxyphenyl is not harmed by the ink component and the aluminium surface is not bared.

Comparative example 2

100 g of the condensed product of 8 parts by weight of 1,2-naphthoquinone-2-diazide-5-sulfonylchloride and 10 parts by weight of resorcine-acetaldehyde resin, and 0.7 g of dyestuff (methylene Blu-Cone by Sumitomo Chemical Industry Co Japan) are dissolved in 1 l of ethylene glycol monoethyl ether by which a photosensitive liquid is prepared. Following the same method as example 1, the said photosensitive liquid is coated onto a sandblasted aluminium plate with a roller, so that the weight of the liquid after drying becomes 1.8 g per sq meter. The thus prepared photosensitive plate is exposed under the same conditions as that of the example 1 and is developed in 2% solution of sodium metasilicate in a similar manner to example 1.

Next, the photosensitive plates according to the example 1 and from this example are compared for their ink receptivity and chemical resistance.

When each of the said plates is used in an offset printer to print under the similar conditions to that of the comparative example 1, the photosensitive substance of resorcine-formaldehyde is found to be inferior in ink receptivity and the spoilage was approximately 2 times more until a printed matter is obtained with sufficient ink density and further its printing durability is approximately 2/3, as compared with the photosensitive plate according to example 1.

The chemical resistance of the said two kinds of the printing plates are compared under similar conditions to that of the comparative example 1. The ratio of image loss of the photosensitive substance of resorcine benzaldehyde after being soaked in 50% solution of isopropyl alcohol is 22 weight per cent, while that of the photosensitive substance of resorcinol-formaldehyde is 55 weight per cent.

Example 2

50 g of condensed product of 20 parts by weight of 1,2-naphthoquinone-2-diazide-5-sulfonylchloride and 10 parts by weight of 2-methylresorcine-acetone resin (obtained according to Synthesis example 2), 70 g of cresol formaldehyde resin (Sumilite Resin PR—SK—1, Registered Trade Mark of Sumitomo Durez Company Ltd Japan) and 1 g of dyestuff (Oil-Blue-2N Registered Trade Mark of Orient Chemical Company) are dissolved in 1 l of ethylene glycol monomethyl ether to prepare a photosensitive liquid, and the said photosensitive liquid is coated onto a sandblasted aluminium plate to 0.30 mm in thickness with a roller so that the weight of the liquid after drying is 2.3 g per sq meter.

A positive transparent original is placed in contact with the surface of the thus prepared photosensitive plate and exposed thereon using a 2 KW metal halide lamp from a distance of 1 meter for 90 seconds. Successively the said photosensitive plate is soaked in a 3% solution of sodium metasilicate, the exposed area is dissolved quickly, and an offset printing plate having superb oil-sensitivity and chemical resistance is obtained. When this printing plate is used on an offset printer to print, the ink receptivity is superior and the spoilage was approximately one third (1/3) and the printing durability thereof is approximately 2 times that of a conventional photosensitive substance using cresol-formaldehyde.

The chemical resistance of said printing plate is tested under similar conditions to those of example 1; the ratio of image loss after soaking in 50% solution of isopropylalcohol proved to be 28 weight per cent.

Further, when the surface of the photosensitive plate is checked after soaking in the ink (PS plate Ink PI—2 made by Fuji Photo Film Co Japan), the aluminium surface is found not to have been harmed by the ink components and also is not bared.

Example 3

100 g of the condensed product of 8 parts by weight of 1,2-naphthoquinone-2-diazide-5-sulfonylchloride and 10 parts by weight of 2-ethylresorcine-benzaldehyde resin (product according to synthesis example 3), and 0.7 g of dyestuff (Victoria Pure Blue BOH, Registered Trade Mark of Hodagaya Chemical Industry Co Japan) are dissolved in 1 l of ethylene glycol monoethyl ether to prepare a photosensitive liquid and the said photosensitive liquid is coated onto a sandblasted aluminium plate using a similar method to that of example 1. After the thus prepared photosensitive plate is exposed to light for 50 secs by means of a method similar to that of example 1, the said plate is developed in a 5% aqueous solution of tertiary sodium phosphate; an offset printing plate having superb oil-sensitivity and chemical resistance is obtained.

When this printing plate is used on an offset printer to print, the ink receptivity is superior and the spoilage approximately 1/4 and the printing durability approximately 2 times that of a conventional photosensitive substance using cresol-formaldehyde.

The chemical resistance of said printing plate is tested under similar conditions to those of example 1; the ratio of the image loss after soaking in a 50% solution of isopropylalcohol is found to be 21 percent by weight and the aluminium surface is not harmed by soaking in ink (PS plate Ink PI—2 made by Fuji Photo Film Co Japan) and is not bared.

**Claims**

1. A condensation product of a sulfonlychloride of an o-benzoquinonediazide or o-naphthoquinonediazide and a polyhydric phenol resin, characterised in that the polyhydric phenol resin possesses 3 or more units having the following general formula:

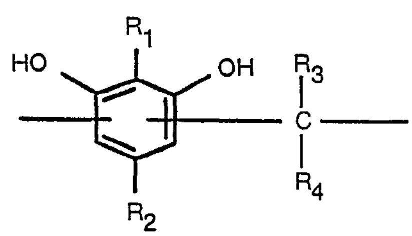

where $R_1$ is an alkyl group having 1 to 8 carbon atoms, $R_2$ is a hydrogen or halogen atom or an alkyl or alkoxy group having 1 to 4 carbon atoms, $R_3$ and $R_4$ are individually a hydrogen atom or an alkyl group having 1 to 4 carbon atoms or a phenyl group.

2. A condensation product according to claim 1 in which $R_2$ represents a hydrogen atom and $R_1$ represents a methyl or ethyl group.

3. A condensation product according to claim 1 in which $R_3$ represents a hydrogen atom or a methyl group and $R_4$ represents a methyl group.

4. A condensation product according to any one of claims 1 to 3 in which the molecular weight of the polyhydric phenol resin is 800 to 4,000.

5. A condensation product according to any one of claims 1 to 4 in which the molar ratio of the sulfonylchloride of o-benzoquinonediazide or o-naphthoquinonediazide to the polyhydric phenol is 1:0.4 to 1:2.

6. A condensation product according to any one of claims 1 to 5 in which the sulfonylchloride is 4-chlorosulfonyl-o-benzoquinonediazide, 4-chlorosulfonyl-o-naphthoquinonediazide or 5-chloro-sulfonyl-o-naphthoquinonediazide, or a substituted derivative thereof.

7. A condensation product according to claim 6 in which the sulfonylchloride is 4-chlorosulfonyl-o-naphthoquinonediazide or 5-chlorosulfonyl-o-naphthoquinonediazide.

8. A condensation product according to any one of claims 1 and 4 to 7 in which the resin is derived from 2-methyl resorcinol, 2-ethylresorcinol, 2-propylresorcinol, 2-isopropyl resorcinol, 2-t-butylresorcinol, 2-pentylresorcinol, 2-hexylresorcinol, 2-octylresorcinol, 2-methyl-5-chlororesorcinol, 2-ethyl-5-chlororesorcinol, 2,5-dimethylresorcinol, 2-methyl-5-ethylresorcinol, 2-methyl-5-methoxy-resorcinol, 2,5-diethylresorcinol or 2-t-butyl-5-methylresorcinol.

9. A photosensitive composition comprising a photosensitive material and a carrier or diluent characterised in that the photosensitive material is a condensation product as claimed in any one of the preceding claims.

10. A photosensitive lithographic printing plate having a photosensitive layer coated on a support characterised in that the layer contains a condensation product as claimed in any one of claims 1 to 8.

**Revendications**

1. Un produit de condensation d'un chlorure de sulfonyle d'un o-benzoquinonediazide ou d'un o-naphtoquinonediazide et d'une résine de phénol polyhydrique, caractérisé en ce que la résine de phénol

polyhydrique possède 3 motifs, ou davantage, ayant la formule générale suivante:

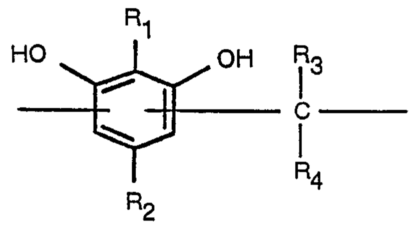

dans laquelle $R_1$ est un groupement alkyle ayant 1 à 8 atomes de carbone, $R_2$ est un atome d'hydrogène ou d'halogène ou un groupement alkyle ou alkoxy ayant 1 à 4 atomes de carbone, $R_3$ et $R_4$ représentent individuellement un atome d'hydrogène ou un groupement alkyle ayant 1 à 4 atomes de carbone ou un groupement phényle.

2. Un produit de condensation selon la revendication 1, dans lequel $R_2$ représente un atome d'hydrogène et $R_1$ représente un groupement méthyle ou éthyle.

3. Un produit de condensation selon la revendication 1, dans lequel $R_3$ représente un atome d'hydrogène ou un groupement méthyle et $R_4$ représente un groupement méthyle.

4. Un produit de condensation selon l'une quelconque des revendications 1 à 3, dans lequel le poids moléculaire de la résine de phénol polyhydrique est de 800 à 4.000.

5. Un produit de condensation selon l'une quelconque des revendications 1 à 4, dans lequel le rapport molaire du chlorure de sulfonyle d'o-benzoquinonediazide ou d'o-naphtoquinonediazide au phénol polyhydrique est de 1:0,4 à 1:2.

6. Un produit de condensation selon l'une quelconque des revendications 1 à 5, dans lequel le chlorure de sulfonyle est le 4-chlorosulfonyle-o-benzoquinonediazide, le 4-chlorosulfonyle-o-naphtoquinonediazide ou le 5-chlorosulfonyle-o-naphtoquinonediazide, ou un dérivé substitué de ces composés.

7. Un produit de condensation selon la revendication 6, dans lequel le clorure de sulfonyle est le 4-chlorosulfonyle-o-naphtoquinonediazide ou le 5-chlorosulfonyle-o-naphtoquinonediazide.

8. Un produit de condensation selon l'une quelconque des revendications 1 et 4 à 7, dans lequel la résine est dérivée du 2-méthyl résorcinol, du 2-éthylrésorcinol, du 2-propylrésorcinol, du 2-isopropyl résorcinol, du 2-t-butyl résorcinol, du 2-pentylrésorcinol, du 2-hexylrésorcinol, du 2-octylrésorcinol, du 2-méthyl-5-chlororésorcinol, du 2-éthyl-5-chlororésorcinol, du 2,5-diméthylrésorcinol, du 2-méthyl-5-éthylrésorcinol, du 2-méthyl-5-méthoxyrésorcinol, du 2,5-diéthylrésorcinol ou du 2-t-butyl-5-méthylrésorcinol.

9. Une composition photosensible comprenant un matériau photosensible et un support ou diluant, caractérisée en ce que le matériau photosensible est un produit de condensation tel que défini dans l'une quelconque des revendications précédentes.

10. Une plaque d'impression lithographique photosensible ayant une couche photosensible appliquée sur un support, caractérisée en ce que la couche contient un produit de condensation tel que défini dans l'une quelconque des revendications 1 à 8.

**Patentansprüche**

1. Kondensationsprodukt aus einem Sulfonylchlorid von einem o-Benzochinondiazid oder einem o-Naphthochinondiazid mit einem Polyhydroxyphenolharz, dadurch gekennzeichnet, daß das Polyhydroxyphenolharz 3 oder mehr Einheiten der nachfolgenden allgemeinen Formel besitzt:

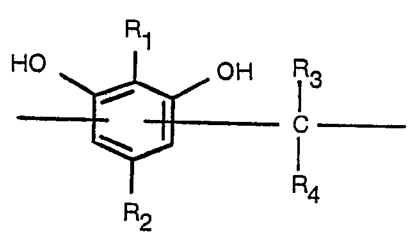

worin $R_1$ eine Alkylgruppe mit 1 bis 8 Kohlenstoffatomen und $R_2$ ein Wasserstoff- oder Halogenatom oder eine Alkyl- oder Alkoxygruppe mit 1 bis 4 Kohlenstoffatomen ist, und $R_3$ und $R_4$ jedes für sich für ein Wasserstoffatom oder eine Alkylgruppe mit 1 bis 4 Kohlenstoffatomen oder für eine Phenylgruppe steht.

2. Kondensationsprodukt nach Anspruch 1, wobei $R_2$ für ein Wasserstoffatom und $R_1$ für eine Methyl- oder Äthylgruppe steht.

3. Kondensationsprodukt nach Anspruch 1, wobei $R_3$ für ein Wasserstoffatom oder eine Methyl-

gruppe und $R_4$ für eine Methylgruppe steht.

4. Kondensationsprodukt nach einem der Ansprüche 1 bis 3, wobei das Molekulargewicht des Polyhydroxyphenolharzes 800 bis 4,000 beträgt.

5. Kondensationsprodukt nach einem der Ansprüche 1 bis 4, wobei das Molverhältnis des Sulfonylchlorids vom o-Benzochinondiazid oder o-Naphthochinondiazid zum Polyhydroxyphenol 1:0.4 bis 1:2 beträgt.

6. Kondensationsprodukt nach einem der Ansprüche 1 bis 5, wobei das Sulfonylchlorid 4-Chlorosulfonyl-o-benzochinondiazid, 4-Chlorosulfonyl-o-naphthochinondiazid oder 5-Chlorosulfonyl-o-naphthochinondiazid oder ein substituiertes Derivat hiervon ist.

7. Kondensationsprodukt nach Anspruch 6, wobei das Sulfonylchlorid 4-Chlorosulfonyl-o-naphthochinondiazid oder 5-Chlorosulfonyl-o-naphthochinondiazid ist.

8. Kondensationsprodukt nach einem der Ansprüche 1 und 4 bis 7, wobei das Harz von 2-Methylresorzin, 2-Äthylresorzin, 2-Propylresorzin, 2-Isopropylresorzin, 2-t-Butylresorzin, 2-Pentylresorzin, 2-Hexylresorzin, 2-Octylresorzin, 2-Methyl-5-chlororesorzin, 2-Äthyl-5-chlororesorzin, 2,5-Dimethylresorzin, 2-Methyl-5-äthylresorzin, 2-Methyl-5-Methyloxyresorzin, 2,5-Diäthylresorzin oder 2-t-Butyl-5-methylresorzin abgeleitet ist.

9. Eine photoempfindliche Zusammensetzung, die ein photoempfindliches Material und einen Träger oder Verdünnungsmittel enthält, dadurch gekennzeichnet, daß es sich bei dem photoempfindlichen Material um ein Kondensationsprodukt wie in einem der vorhergehenden Ansprüche angegeben handelt.

10. Eine photoempfindliche lithographische Druckplatte mit einer als Überzug auf einem Träger aufgebrachten photoempfindlichen Schicht, dadurch gekennzeichnet, daß die Schicht ein Kondensationsprodukt wie in einem der vorhergehenden Ansprüche 1 bis 8 angegeben enthält.